# EUROPÄISCHE PATENTSCHRIFT

(11) **EP 3 815 194 B1**
(45) Veröffentlichungstag und Bekanntmachung des Hinweises auf die Patenterteilung: **26.04.2023**
(21) Anmeldenummer: 18739476.2
(22) Anmeldetag: 29.06.2018
(51) Int. Cl.: H01R 13/05, H01R 13/193, H01R 13/66

(54) **HOCHSTROMKONTAKT ZUM KONTAKTIEREN EINER HOCHSTROMBUCHSE**
HIGH CURRENT CONTACT FOR CONTACTING A HIGH CURRENT SOCKET
CONTACT À COURANT ÉLEVÉ DESTINÉ À VENIR EN CONTACT AVEC UNE PRISE FEMELLE À COURANT ÉLEVÉ

(43) Veröffentlichungstag der Anmeldung: 05.05.2021
(73) Patentinhaber: Lisa Dräxlmaier GmbH, 84137 Vilsbiburg (DE); PTR Hartmann GmbH, 59368 Werne (DE)
(72) Erfinder: KAGERHUBER, Manuel, 84140 Gangkofen (DE); MAYER, Anton, 84137 Seyboldsdorf (DE); BRIESEMANN, Andreas, 44534 Lünen (DE)
(86) Internationale Anmeldenummer: PCT/EP2018/067563
(87) Internationale Veröffentlichungsnummer: WO 2020/001782

(56) Entgegenhaltungen:
- WO-A1-02/13330
- WO-A1-2012/136562
- DE-A1-102014 114 141
- JP-U- S57 161 876

## Beschreibung

### Technisches Gebiet

Die vorliegende Erfindung betrifft einen Hochstromkontakt zum Kontaktieren einer Hochstrombuchse.

### Stand der Technik

Insbesondere aufgrund der zunehmenden Elektrifizierung von Kraftfahrzeugen ist es im Rahmen der Produktion von Hochvolt-Komponenten für Kraftfahrzeuge zunehmend erforderlich, zur Funktionsüberprüfung und/oder zu Testzwecken - beispielsweise in so genannten End-of-Line-Tests - Hochstromkontakte mit Hochstrombuchsen zu verbinden. Über derartige Hochstrombuchsen fließen sehr hohe Ströme, teilweise von mehr als 1000 Ampere, zumindest kurzzeitig. Dauerströme von circa 500 Ampere sind dabei auch nicht unüblich. Derartige Hochstromkontakte, welche zur Überprüfung verschiedenster elektrischer Komponenten mit Hochstrombuchsen verbunden werden müssen, müssen einerseits sehr hohe Ströme verkraften und andererseits im laufenden Produktions- beziehungsweise Prüfbetrieb sehr viele Steckzyklen verkraften. Die WO 2012 / 136562 A1 offenbart einen Prüfstift zum Kontaktieren eines elektrisch leitenden Bereichs eines Kontaktpartners, gemäß dem Oberbegriff des Anspruchs 1. Die WO 02 / 13330 A1 offenbart ein elektrischen Steckverbinder.

### Beschreibung der Erfindung

Es ist daher die Aufgabe der vorliegenden Erfindung, einen Hochstromkontakt zum Kontaktieren einer Hochstrombuchse bereitzustellen, welcher für eine Vielzahl von Prüfzyklen und hohe Ströme geeignet ist.

Diese Aufgabe wird durch einen Hochstromkontakt zum Kontaktieren einer Hochstrombuchse mit den Merkmalen des Patentanspruchs 1 gelöst. Vorteilhafte Ausgestaltungen mit zweckmäßigen und nicht-trivialen Weiterbildungen der Erfindung sind in den abhängigen Ansprüchen angegeben.

Der erfindungsgemäße Hochstromkontakt zum Kontaktieren einer Hochstrombuchse umfasst einen Kontaktstift zum Einführen in die Hochstrombuchse mit mehreren in radialer Richtung geschlitzten Kontaktsegmenten zum Kontaktieren einer Innenkontaktfläche der Hochstrombuchse. Die in radialer Richtung geschlitzten Kontaktsegmente sind dabei in radialer Richtung vorgespannt. Dies bedeutet, dass die Kontaktsegmente des Kontaktstifts ohne äußere Krafteinwirkung bezogen auf eine Längsachse des Kontaktstifts konisch aufgeweitet sind.

Der Hochstromkontakt umfasst zudem eine den Kontaktstift umgebende Führungshülse, die durch zumindest mittelbares stirnseitiges Andrücken an die Hochstrombuchse relativ zum Kontaktstift in axialer Richtung von einer Ausgangsstellung in eine gegenüber dem Kontaktstift zurückversetzte Kontaktstellung bewegbar ist. Die Führungshülse ist dabei derart gestaltet, dass diese in der Ausgangsstellung zur Vermeidung einer Berührung zwischen den axial aus der Führungshülse herausragenden Kontaktsegmenten und der Innenkontaktfläche ein eigenständiges radiales Aufspreizen der Kontaktsegmente sperrt. In der gegenüber dem Kontaktstift zurückversetzten Kontaktstellung ergibt die Führungshülse ein eigenständiges radiales Aufspreizen der radial aus der Führungshülse herausragenden Kontaktsegmente zum Kontaktieren der Innenkontaktfläche der Hochstrombuchse frei.

Zum Herstellen eines elektrisch leitenden Kontakts zwischen dem Hochstromkontakt und der Hochstrombuchse muss der Hochstromkontakt also lediglich stirnseitig an die Hochstrombuchse angedrückt werden. Im kraftfreien beziehungsweise mechanisch unbelasteten Zustand befindet sich die Führungshülse automatisch in der besagten Ausgangsstellung, in der die Führungshülse ein eigenständiges radiales Aufspreizen der Kontaktsegmente sperrt. In der Ausgangsstellung ist also ein maximaler Außendurchmesser der Kontaktsegmente des Kontaktstifts kleiner als ein Innendurchmesser der Hochstrombuchse. Dadurch kann der Kontaktstift mitsamt seinen Kontaktsegmenten ohne die Innenkontaktfläche der Hochstrombuchse zu berühren in diese eingeführt werden.

Während dieses Einführungsvorgangs übt die Hochstrombuchse zumindest mittelbar stirnseitig einen Druck beziehungsweise eine Kraft auf die Führungshülse aus. Infolgedessen verschiebt sich die Führungshülse relativ zu den Kontaktsegmenten des Kontaktstifts von der Ausgangsstellung in die besagte zurückversetzte Kontaktstellung. Diese zurückversetzte Kontaktstellung entspricht einer Art Endposition beziehungsweise Endstellung, in welcher die elektrische Kontaktierung zwischen dem Hochstromkontakt und der Hochstrombuchse hergestellt wird. Dadurch, dass die geschlitzten Kontaktsegmente des Kontaktstifts in radialer Richtung vorgespannt sind, streben diese ohne äußere Krafteinwirkung in radialer Richtung nach außen. In der zurückversetzten Kontaktstellung der Führungshülse gibt diese ein eigenständiges radiales Aufspreizen der axial aus der Führungshülse herausragenden Kontaktsegmente frei. Infolgedessen spreizen sich die Kontaktsegmente des Kontaktstifts soweit radial nach außen, dass diese in Kontakt mit der Innenkontaktfläche der Hochstrombuchse gelangen. Infolgedessen wird eine zuverlässige Kontaktierung zwischen dem Hochstromkontakt und der Hochstrombuchse erzielt.

Die geschlitzten Kontaktsegmente des Kontaktstifts wirken also wie eine Art Spannzange, welche beim Einführen in die Hochstrombuchse radial aufgespreizt werden können. Beim Einfahren und Ausfahren des Hochstromkontakts in die Hochstrombuchse beziehungsweise aus dieser heraus hat der Hochstromkontakt also nur einen stirnseitigen Kontakt mit der als Prüfling dienenden Hochstrombuchse. Beim Hineinbewegen der Kontaktsegmente in die Hochstrombuchse hinein und aus dieser wieder heraus kann also vermieden werden, dass die Kontaktsegmente an der Innenfläche der Hochstrombuchse reiben beziehungsweise schleifen. Beschädigungen an der Oberfläche der Innenkontaktfläche oder Beschädigungen an den Kontaktsegmenten können dadurch vermieden werden. Insbesondere kann der Hochstromkontakt für eine Vielzahl von Steckzyklen zum Überprüfen einer Vielzahl von Hochstrombuchsen verwendet werden, ohne dass die Kontaktsegmente und die jeweiligen Innenkontaktflächen der zu prüfenden Hochstrombuchsen in Mitleidenschaft gezogen werden. Der erfindungsgemäße Hochstromkontakt ermöglicht mit anderen Worten also eine beschädigungsfreie Kontaktierung der Hochstrombuchse.

Zudem mündet in zumindest einem Kontaktbereich der Kontaktsegmente eine Prüfleitung zum Messen wenigstens einer physikalischen Eigenschaft. Bei der physikalischen Eigenschaft handelt es sich vorzugsweise um einen elektrischen Widerstand und/oder um eine Temperatur. So ist es mittels des erfindungsgemäßen Hochstromkontakts möglich, einen Widerstand und/oder eine Temperatur in zumindest einem Kontaktbereich der Kontaktsegmente zu messen. Nur eine einwandfreie Kontaktierung der Hochstrombuchse garantiert eine qualitativ hochwertige und reproduzierbare Messung. Dies kann über besagte Widerstandsmessung überwacht werden. Ferner können aufgrund der hohen möglichen Ströme zwischen Hochstromkontakt und Hochstrombuchse sehr hohe Temperaturen auftreten. Durch eine Temperaturmessung im Kontaktbereich kann sichergestellt werden, dass keine zu hohen Temperaturen auftreten, welche den Hochstromkontakt und/oder die Hochstrombuchse schädigen könnten.

Eine vorteilhafte Ausführungsform der Erfindung sieht vor, dass, im zumindest einen Kontaktbereich der Kontaktsegmente ein Sensormittel zum Messen wenigstens einer physikalischen Eigenschaft angeordnet und mit der Prüfleitung verbunden ist. Bei der physikalischen Eigenschaft kann es sich um eine Temperatur und/oder einen Widerstand handeln. So kann es sich um ein Sensormittel zur Widerstandsmessung und/oder Temperaturmessung handeln, wobei das Sensormittel ausgebildet ist, die Widerstandsmessung repräsentierende Messdaten und/oder die Temperaturmessung repräsentierende Messdaten über die Prüfleitung an eine übergeordnete Steuereinheit zu übertragen.

Die Erfindung sieht vor, dass die Führungshülse einen konischen Innenabschnitt aufweist, der beim Bewegen der Führungshülse von der Ausgangsstellung in die zurückversetzte Kontaktstellung mit einem konischen Außenabschnitt des Kontaktstifts zusammenwirkt und dadurch das eigenständige Aufspreizen der Kontaktsegmente freigibt. Durch die aufeinander abgestimmten konischen Abschnitte in Form des Innenabschnitts der Führungshülse und des konischen Außenabschnitts des Kontaktstifts wird also ein kontrolliertes radiales Aufspreizen der Kontaktsegmente auf zuverlässige Weise ermöglicht.

Eine weitere vorteilhafte Ausführungsform der Erfindung sieht vor, dass die Führungshülse unter Vermittlung einer Rückstellfeder axial beweglich in einem Gehäuseteil gelagert ist, welche auf die Führungshülse eine Rückstellkraft in Richtung der Ausgangsstellung ausübt. Beim Hineinbewegen des Kontaktstifts in die Hochstrombuchse übt die Rückstellfeder also eine Gegenkraft aus. Wird auf den Hochstromkontakt nach dem Einführen in die Hochstrombuchse keine Kraft mehr ausgeübt, so sorgt die Rückstellfeder dafür, dass die Führungshülse wieder in die Ausgangsstellung zurück bewegt wird. Beim Herausziehen des Hochstromkontakts aus der Hochstrombuchse kann also sichergestellt werden, dass die Kontaktsegmente aufgrund der Bewegung der Führungshülse wieder radial zusammen gedrückt werden, infolgedessen auch beim Herausführen des Kontaktstifts aus der Hochstrombuchse kein Kontakt mehr zwischen den Kontaktsegmenten und der Innenkontaktfläche der Hochstrombuchse besteht.

Gemäß einer weiteren vorteilhaften Ausführungsform der Erfindung ist es vorgesehen, dass der Kontaktstift unter Vermittlung einer Feder mit der Führungshülse verbunden ist. Stößt man versehentlich an den Kontaktstift, beispielsweise bei dem Versuch, den Kontaktstift in die Hochstrombuchse einzuführen, so sorgt die Feder dafür, dass der Kontaktstift in die Führungshülse gedrückt wird. Dadurch können Beschädigungen am Kontaktstift vermieden werden. Die Feder dient also als mechanischer Schutz vor einer Überlastung des Kontaktstifts.

In weiterer vorteilhafter Ausgestaltung der Erfindung ist es vorgesehen, dass der Kontaktstift einen sich radial nach außen erstreckenden Kragen aufweist, welcher eine Bewegung der Führungshülse von der zurückversetzten Kontaktstellung über die Ausgangsstellung hinaus verhindert. Die Relativbewegung der Führungshülse über die Ausgangsstellung hinaus kann dadurch zuverlässig unterbunden werden. Folglich verbleibt der Kontaktstift immer zuverlässig innerhalb der Führungshülse.

Eine weitere vorteilhafte Ausführungsform der Erfindung sieht vor, dass auf die Führungshülse eine Mutter mit einer stirnseitigen Anlagefläche für die Hochstrombuchse geschraubt ist, wobei durch axiale Positionsveränderung der Mutter die zurückversetzte Kontaktstellung der Führungshülse und damit die mittels der Kontaktsegmente auf die Innenkontaktfläche der Hochstrombuchse ausübbare Kontaktkraft veränderbar ist. Zur axialen Positionsveränderung muss die Mutter einfach nur verdreht werden, sodass diese in axialer Richtung auf der Hochstrombuchse entlang wandert. Je nach Positionierung der Mutter ergibt sich eine Veränderung der zurückversetzten Kontaktstellung der Führungshülse. Je weitere die geschlitzten Kontaktsegmente in axialer Richtung aus der Führungshülse heraus ragen können, desto weniger hemmt die Führungshülse das selbstständige beziehungsweise eigenständige Aufspreizen der Kontaktsegmente. Auf diese Weise kann die ausübbare Kontaktkraft der Kontaktsegmente auf die Innenkontaktfläche der Hochstrombuchse variiert werden.

Gemäß einer weiteren vorteilhaften Ausführungsform der Erfindung ist es vorgesehen, dass im zumindest einen Kontaktbereich der Kontaktsegmente ein Sensormittel zur Widerstandsmessung angeordnet und mit der Prüfleitung verbunden ist, wobei das Sensormittel ausgebildet ist, die Widerstandsmessung repräsentierende Messdaten über die Prüfleitung an eine übergeordnete Steuereinheit zu übertragen. Das Sensormittel ist vorzugsweise federnd angebracht, beispielsweise durch eine Lagerung auf einem Silikonbett, welches elastisch verformbar ist. Mittels dieses Sensormittels kann eine Vierleiter- oder Kelvinmessung am eingebrachten Kontaktstift durchgeführt werden. Die Vierleitermessung wird bei der Messung von elektrischen Widerständen mit einem Vierleiteranschluss eingesetzt, wenn Leitungs- und Anschlusswiderstände die Messung verfälschen könnten. Bei der Vierleiter-Messanordnung fließt über zwei der Leitungen ein bekannter elektrischer Strom durch den Widerstand. Die am Widerstand abfallende Spannung wird hochohmig über zwei weitere Leitungen abgegriffen und mit einem Spannungsmessgerät gemessen. Der zu messende Widerstand wird daraus nach dem ohmschen Gesetz berechnet. Das Prinzip gilt analog bei der Strommessung mittels eines niederohmigen Shunts. Hierbei wird die unbekannte Stromstärke durch einen bekannten Widerstand mittels der abfallenden Spannung ermittelt. Bei der Vierleiter- oder Kelvinmessung werden die Zuleitungswiderstände der Messleitungen und die Übergangswiderstände an den Messstellen zwischen Hochstrombuchse und Messgerät kompensiert. Für den Einsatz von Kapazitäts- oder Induktivitätsmessungen gilt das gleiche Prinzip. Nur eine einwandfreie Kontaktierung der Hochstrombuchse garantiert eine qualitativ hochwertige und reproduzierbare Messung. Um der ständig wachsenden technischen Entwicklung gerecht zu werden, müssen die Anforderungen an die Kontaktierung der Hochstrombuchse stetig angepasst werden. Das Sensormittel ist durch Anschlussmittel mit der Prüfleitung verbunden und gemessene Daten werden über die Prüfleitung an eine Steuereinheit gesendet und dort ausgewertet. Das Sensormittel ist bevorzugt ausgebildet, elektrische Widerstände der Hochstrombuchse zu messen.

Eine weitere vorteilhafte Ausführungsform der Erfindung sieht vor, dass im zumindest einen Kontaktbereich der Kontaktsegmente ein Sensormittel zur Temperaturmessung angeordnet und mit der Prüfleitung verbunden ist, wobei das Sensormittel ausgebildet ist, die Temperaturmessung repräsentierende Messdaten über die Prüfleitung an die übergeordnete Steuereinheit oder eine weitere Steuereinheit zu übertragen. Bevorzugt ist dieses Sensormittel ein Temperaturfühler, der am zumindest einen Kontaktbereich der Kontaktsegmente anliegt. Mittels dieses weiteren Sensormittels kann insbesondere die Temperatur innerhalb des Hochstromkontakts gemessen werden. Beim Überprüfen der Hochstrombuchse mittels des Hochstromkontakts können Dauerströme von circa 500 Ampere und Spitzenströme von 1000 Ampere auftreten. Dabei können sich der Hochstromkontakt und die Hochstrombuchse stark erhitzen. Mittels des Sensormittels zur Temperaturmessung können jeweilige Temperaturen am Hochstromkontakt und der Hochstrombuchse zuverlässig überwacht werden. Für beide Arten von Prüfleitungen, also zur Widerstandsmessung und zur Temperaturmessung, kann der Kontaktstift jeweilige Nuten aufweisen, in welchen jeweilige Prüfleitungen angeordnet sind. Dadurch können die Prüfleitungen in axialer Richtung entlang des Kontaktstifts beispielsweise an ein von den Kontaktsegmenten abgewandtes Ende geführt werden.

Gemäß einer weiteren vorteilhaften Ausführungsform der Erfindung ist es vorgesehen, dass der Kontaktstift eine Kühlmittelbohrung zum Zuführen eines gasförmigen Kühlmediums zu den Kontaktsegmenten aufweist. Die Kühlmittelbohrung kann sich beispielsweise entlang der gesamten Längsachse des Kontaktstifts erstrecken. So kann auf einfache Weise bei Bedarf das gasförmige Kühlmedium, beispielsweise in Form von Druckluft oder dergleichen, den Kontaktsegmenten zugeführt werden. Fließen hohe Ströme zwischen Hochstromkontakt und angeschlossener Hochstrombuchse, so können die Kontaktsegmente auf zuverlässige Weise gekühlt werden.

In weiterer vorteilhafter Ausgestaltung der Erfindung ist es vorgesehen, dass der Kontaktstift auf seinem von den Kontaktsegmenten abgewandten Längsende einen Anschluss zum Zuführen des gasförmigen Kühlmediums aufweist. So kann auf besonders einfache Weise das gasförmige Kühlmedium der Kühlmittelbohrung und letztlich den Kontaktsegmenten zugeführt werden.

Schließlich sieht eine weitere vorteilhafte Ausführungsform der Erfindung vor, dass der Hochstromkontakt eine Nickel-Silber-Beschichtung aufweist. Dies trägt dazu bei, die Lebensdauer des Hochstromkontakts zu erhöhen und die elektrische Kontaktierung zwischen Hochstromkontakt und Hochstrombuchse zu verbessern.

Weitere Vorteile, Merkmale und Einzelheiten der Erfindung ergeben sich aus der nachfolgenden Beschreibung eines bevorzugten Ausführungsbeispiels sowie anhand der Zeichnung. Die vorstehend in der Beschreibung genannten Merkmale und Merkmalskombinationen sowie die nachfolgend in der Figurenbeschreibung genannten und/oder in den Figuren alleine gezeigten Merkmale und Merkmalskombinationen sind nicht nur in der jeweils angegebenen Kombination, sondern auch in anderen Kombinationen oder in Alleinstellung verwendbar, ohne den Rahmen der Erfindung zu verlassen.

### Kurze Figurenbeschreibung

Die Zeichnung zeigt in:
- Fig. 1: eine Perspektivansicht einer Hochstrombuchse mit einer Innenkontaktfläche zur elektrisch leitenden Kontaktierung mit einem Hochstromkontakt;
- Fig. 2: eine Perspektivansicht des Hochstromkontakts zum Kontaktieren der Hochstrombuchse, wobei der Hochstromkontakt einen Kontaktstift zum Einführen in die Hochstrombuchse mit mehreren in radialer Richtung geschlitzten Kontaktsegmenten zum Kontaktieren der Innenkontaktfläche der Hochstrombuchse sowie eine den Kontaktstift umgebende Führungshülse aufweist, aus welchen die Kontaktsegmente teilweise heraus ragen; und in
- Fig. 3: eine Seitenschnittansicht des Hochstromkontakts.

In den Figuren sind gleiche oder funktionsgleiche Elemente mit den gleichen Bezugszeichen versehen worden.

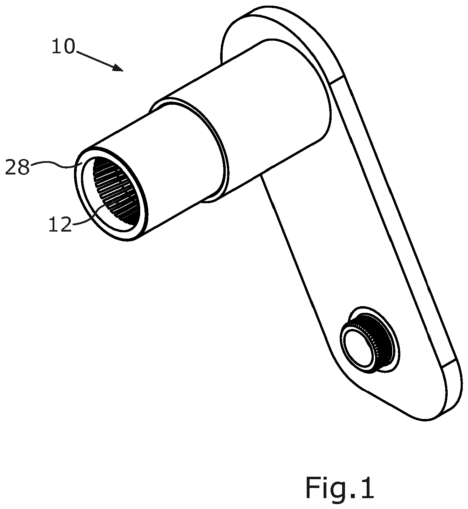

Eine Hochstrombuchse 10 ist in einer Perspektivansicht in Fig. 1 gezeigt. Die Hochstrombuchse 10 umfasst eine Innenkontaktfläche 12 zum elektrisch leitenden Kontaktieren mit einem hier nicht dargestellten Hochstromkontakt 14. Die Hochstrombuchse 10 kann an unterschiedlichsten Komponenten verbaut sein, wie beispielsweise einer so genannten S-Box für ein elektrisch angetriebenes Kraftfahrzeug. Um die zuverlässige Funktionsfähigkeit der Hochstrombuchse 10 sicherzustellen, kann es beispielsweise in einer so genannten End-of-Line-Prüfung vorgesehen sein, diese mittels des besagten Hochstromkontakts 14 zu prüfen. Dabei sind sehr hohe Ströme möglich, beispielsweise von mehr als 1000 Ampere, zumindest kurzzeitig. Darüber hinaus können auf Dauerströme von circa 500 Ampere während des Prüfvorgangs auftreten.

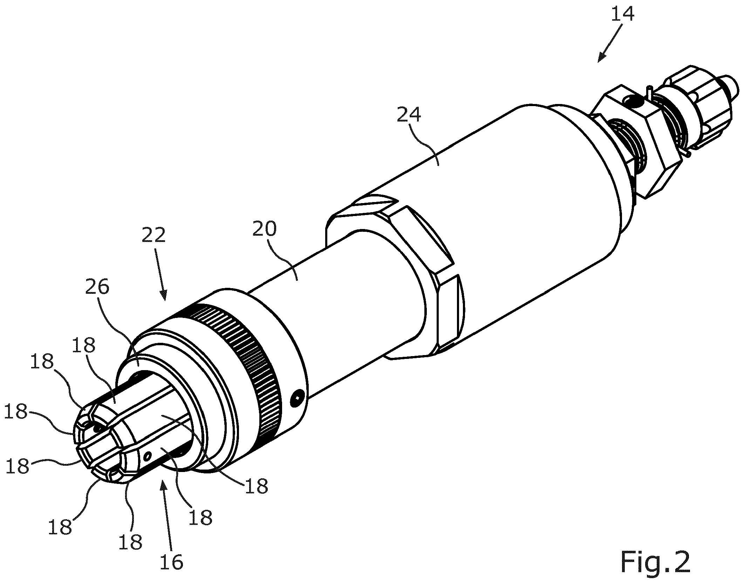

In Fig. 2 ist der besagte Hochstromkontakt 14 zum Kontaktieren der Hochstrombuchse 10 in einer Perspektivansicht gezeigt. Der Hochstromkontakt 14 wird vorzugsweise aus einer hochleitfähigen Kupferlegierung hergestellt. Zudem kann der Hochstromkontakt 14 beispielsweise mit einer Nickel-Silber-Beschichtung versehen sein, um die Lebensdauer zu erhöhen und den elektrischen Kontakt zwischen Hochstromkontakt 14 und der Hochstrombuchse 10 zu optimieren.

Der Hochstromkontakt 14 umfasst einen Kontaktstift 16 zum Einführen in die Hochstrombuchse 10 mit mehreren in radialer Richtung geschlitzten Kontaktsegmenten 18 zum Kontaktieren der Innenkontaktfläche 12 der Hochstrombuchse 10. Die geschlitzten Kontaktsegmente 18 sind in radialer Richtung vorgespannt. Dies bedeutet, dass die Kontaktsegmente 18 im mechanisch unbelasteten Zustand sich nach radial außen aufbiegen würden, sodass die Kontaktsegmente 18 eine Art Konusform ausbilden würden.

Der Hochstromkontakt 14 umfasst des Weiteren eine den Kontaktstift 16 umgebende Führungshülse 20. Auf die Führungshülse 20 ist eine Mutter 22 aufgeschraubt. Die Führungshülse 20 ist axial beweglich in einem Gehäuseteil 24 gelagert. Zum Kontaktieren des Hochstromkontakts 14 mit der Hochstrombuchse 10 wird der Kontaktstift 16 in die Hochstrombuchse 10 eingeführt. Dabei gelangt eine stirnseitige Anlagefläche 26 der Mutter 22 in Kontakt mit einer stirnseitigen Anlagefläche 28 der Hochstrombuchse 10. Wird der Hochstromkontakt 14 nun weiter auf die Hochstrombuchse 10 gedrückt, so wird aufgrund des Kontakts zwischen den stirnseitigen Anlageflächen 26, 28 die Führungshülse 20 relativ zum Kontaktstift 16 nach hinten verschoben.

Die innerhalb des Gehäuseteils 24 axial beweglich gelagerte Führungshülse 20 kann dabei von einer hier gezeigten Ausgangsstellung in eine gegenüber dem Kontaktstift 16 zurückversetze Kontaktstellung bewegt werden. In der Ausgangsstellung der Führungshülse 20 verhindert diese ein eigenständiges radiales Aufspreizen der Kontaktsegmente 18. Die radial vorgespannten Kontaktsegmente 18 werden dabei mittels der Führungshülse 20 derart in radialer Richtung zusammengedrückt gehalten, dass ihr Außendurchmesser kleiner als der Innendurchmesser der Innenkontaktfläche 12 beziehungsweise des Innendurchmessers der Hochstrombuchse 10 ist. Der Kontaktstift 16 kann also berührungslos in die Hochstrombuchse 10 eingeführt werden, da die geschlitzten Kontaktsegmente 18 in radialer Richtung zusammengedrückt gehalten werden.

Sobald der Hochstromkontakt 14 fest genug auf die Hochstrombuchse 10 gedrückt worden ist, wird die Führungshülse 20 in die zurückversetzte Kontaktstellung bewegt, in der die Kontaktsegmente 18 weiter als in der hier gezeigten Ausgangsstellung aus der Führungshülse 20 in axialer Richtung herausragen. In dieser zurückversetzten Kontaktstellung der Führungshülse 20 gibt diese ein eigenständiges radiales Aufspreizen der axial aus der Führungshülse 20 herausragenden Kontaktsegmente 18 zum Kontaktieren der Innenkontaktfläche 12 der Hochstrombuchse 10 frei. Je weiter also die Führungshülse 20 von der hier gezeigten Ausgangsstellung nach hinten verschoben wird, desto weiter ermöglicht diese ein radiales Aufspreizen der Kontaktsegmente 18. Spätestens mit Erreichen der zurückversetzten Kontaktstellung haben sich die Kontaktsegmente 18 so weit in radialer Richtung aufgespreizt, dass diese an der Innenkontaktfläche 12 der Hochstrombuchse 10 anliegen. Dadurch wird eine zuverlässige elektrische Kontaktierung zwischen dem Hochstromkontakt 14 und der Hochstrombuchse 10 sichergestellt.

Beispielsweise kann der Außendurchmesser der geschlitzten Kontaktsegmente 18 in der hier gezeigten Ausgangsstellung der Führungshülse 20 circa 12,7 bis 13,4 Millimeter aufweisen. Beim Erreichen der zurückversetzten Kontaktstellung der Führungshülse 20 weiten sich die Kontaktsegmente 18 in radialer Richtung beispielsweise bis auf 15 Millimeter auf. Ein Arbeitshub der Führungshülse 20 von der Ausgangsstellung bis in die zurückversetzte Kontaktstellung kann dabei beispielsweise 6-7 Millimeter betragen.

Die radial vorgespannten geschlitzten Kontaktsegmente 18 wirken also wie eine Art Spannzange, welche sich eigenständig radial aufweiten beziehungsweise aufspreizen können, wenn die Führungshülse 20 im Zuge des Andrückens des Hochstromkontakts 14 an die Hochstrombuchse 10 zurückgedrückt wird. Die Kontaktsegmente 18 können dabei beschädigungsfrei in die Hochstrombuchse 10 eingeführt werden, da während des Einführvorgangs die Kontaktsegmente 18 nicht an der Innenkontaktfläche 12 der Hochstrombuchse 10 schleifen. Insbesondere wird eine Abnutzung beziehungsweise Beschädigung der Kontaktsegmente 18 verhindert, sodass der Hochstromkontakt 14 für eine Vielzahl von Steckzyklen beziehungsweise Prüfzyklen bei ganz vielen Hochstrombuchsen 10 eingesetzt werden kann.

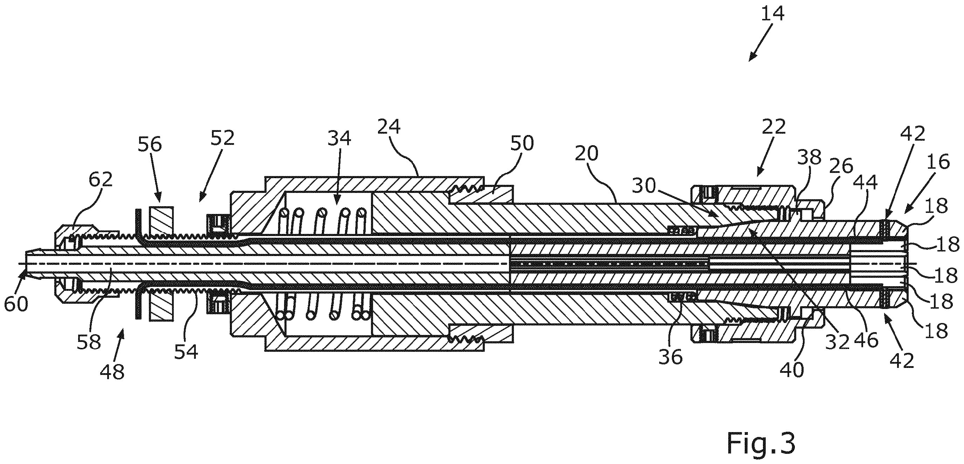

In Fig. 3 ist der Hochstromkontakt 14 in einer Querschnittsansicht gezeigt. Die Führungshülse 20 weist einen konischen Innenabschnitt 30 auf, der beim Bewegen der Führungshülse 20 von der Ausgangsstellung in die zurückversetzte Kontaktstellung mit einem konischen Außenabschnitt 32 des Kontaktstifts 16 zusammenwirkt und dadurch das eigenständige Aufspreizen der Kontaktsegmente 18 freigibt. Die Führungshülse 20 ist hier wiederum in ihrer Ausgangsstellung gezeigt, in der diese zur Vermeidung einer Berührung zwischen den axial aus der Führungshülse 20 herausragenden Kontaktsegmenten 18 und der Innenkontaktfläche 12 der Hochstrombuchse 10 ein eigenständiges radiales Aufspreizen der Kontaktsegmente 18 sperrt. Wie zu erkennen, sind die Kontaktsegmente 18 in dieser Ausgangsstellung parallel zur Längssachse des Hochstromkontakts 14 ausgerichtet.

Die Führungshülse 20 ist unter Vermittlung einer Rückstellfeder 34 axial beweglich im Gehäuseteil 24 gelagert, welche auf die Führungshülse 20 eine Rückstellkraft in Richtung der Ausgangsstellung ausübt. Die Rückstellfeder 34 drückt also die Führungshülse 20 gemäß der vorliegenden Darstellung nach rechts. Wird der Hochstromkontakt 14 nicht mehr an die Hochstrombuchse 10 gedrückt, so sorgt die Rückstellfeder 34 also automatisch dafür, dass die Führungshülse 20 nach rechts verschoben wird, also in ihre hier gezeigte Ausgangsstellung. Der konische Innenabschnitt 30 und der konische Außenabschnitt 32 gleiten entsprechend aneinander entlang, infolgedessen die zuvor noch aufgespreizten Kontaktsegmente 18 wieder in radialer Richtung zusammengedrückt werden. So können die Kontaktsegmente 18 ohne an der Innenkontaktfläche 12 der Hochstrombuchse 10 zu schleifen aus der Hochstrombuchse 10 herausgezogen werden.

Der Kontaktstift 16 ist unter Vermittlung einer Feder 36 mit der Führungshülse 20 verbunden. Diese Feder 36 dient als mechanischer Schutz vor Überlastung, beispielsweise wenn eine Druckkraft auf den Kontaktstift 16 ausgeübt wird. Wird der Hochstromkontakt 14 bei dem Versuch den Kontaktstift 16 in die Hochstrombuchse 10 einzuführen beispielsweise versehentlich stirnseitig auf die stirnseitige Anlagefläche 28 der Hochstrombuchse 10 gedrückt, so kann die Feder 36 gestaucht werden, infolgedessen eine Beschädigung an den Kontaktsegmenten 18 vermieden werden kann.

Der Kontaktstift 16 weist einen sich radial nach außen erstreckenden Kragen 38 auf, welcher eine Bewegung der Führungshülse 20 von der zurückversetzten Kontaktstellung über die Ausgangsstellung hinaus verhindert. Wie zu erkennen, liegt die Führungshülse 20 stirnseitig an dem Kragen 38 an. Die Rückstellfeder 34 kann die Führungshülse 20 also nicht über die hier gezeigte Position hinaus relativ zum Kontaktstift 16 verschieben.

Gegenüberliegend von der stirnseitigen Anlagefläche 26 der Mutter 22 befindet sich eine weitere Anlagefläche 40. Im Zusammenspiel mit dem sich radial nach außen erstreckenden Kragen 38 des Kontaktstifts 16 sorgt diese Anlagefläche 40 dafür, dass eine Verschiebung der Führungshülse 20 aus der Ausgangsstellung - gemäß der vorliegenden Darstellung - nach links in Richtung der zurückversetzten Kontaktstellung begrenzt wird. Durch Andrücken beziehungsweise Anpressen des Hochstromkontakts 14 mit der stirnseitigen Anlagefläche 26 der Mutter 22 an die stirnseitige Anlagefläche 28 der Hochstrombuchse 10 kann die Führungshülse 20 nur so weit zurückgeschoben werden, bis die Anlagefläche 40 der Mutter 22 in Anlage mit dem Kragen 38 gerät. Ein Überdrücken über die zurückversetzte Kontaktstellung ist also nicht möglich. Infolgedessen ist auch ein ungewolltes zu weites Aufspreizen der radial vorgespannten Kontaktsegmente 18 ebenfalls nicht möglich.

Durch eine axiale Positionsveränderung der Mutter 22 kann die zurückversetzte Kontaktstellung der Führungshülse 20 und damit die mittels der Kontaktsegmente 18 auf die Innenkontaktfläche 12 der Hochstrombuchse 10 ausübbare Kontaktkraft verändert werden.

Die Mutter 22 muss also einfach nur gemäß der vorliegenden Darstellung weiter nach links oder rechts geschraubt werden, um den maximalen Abstand zwischen der Anlagefläche 40 der Mutter 22 und dem Kragen 38 des Kontaktstifts zu variieren. Je weiter die Mutter 22 gemäß der vorliegenden Darstellung nach rechts, also in Richtung des freien Endes des Kontaktstifts 16 geschraubt wird, desto weiter kann die Führungshülse 20 vom freien Ende des Kontaktstifts 16 weg bewegt werden. Dadurch kann eingestellt werden, wie weit sich die Kontaktsegmente 18 aufweiten können. Natürlich wird die Aufweitung der Kontaktsegmente 18 durch die Hochstrombuchse 10 begrenzt, wenn die Kontaktsegmente in die Hochstrombuchse 10 eingeführt sind. Durch Variierung der axialen Positionierung der Mutter 22 kann somit die Anpresskraft der Kontaktsegmente 18 auf die Innenkontaktfläche 12 variiert werden.

Zwei der Kontaktsegmente 18 weisen eine jeweilige Bohrung 42 in ihren jeweiligen Kontaktbereichen auf, welche mit der Innenkontaktfläche 12 der Hochstrombuchse 10 kontaktiert werden können. An den Bohrungen 42 mündet jeweils eine Prüfleitung 44 ,46 zur Widerstandsmessung und eine weitere nicht näher dargestellte Prüfleitung zur Temperaturmessung. Mittels der Prüfleitungen 44, 46 ist beispielsweise eine Vierpolmessung beziehungsweise Kelvinmessung möglich, um elektrische Widerstände zu messen. In den Bohrungen 42 können hier nicht näher bezeichnete Sensormittel, z.B. in Form von Kelvinkontakten, zur Vierleitermessung integriert sein.

Die nicht näher dargestellte Prüfleitung zur Temperaturmessung dient zur Temperaturüberwachung während eines Prüfvorgangs, wenn der Hochstromkontakt 14 elektrisch leitend mit der Hochstrombuchse 10 kontaktiert worden ist. In zumindest einem Kontaktbereich der Kontaktsegmente 18 ist ein Sensormittel, beispielsweise ein Temperaturfühler, zur Temperaturmessung angeordnet.

Die Prüfleitungen 44, 46 sowie die nicht weiter dargestellte Prüfleitung zur Temperaturmessung und hier nicht näher dargestellten Sensoremittel sind für Temperaturen höher als 200 Grad ausgelegt. Die Prüfleitungen 44, 46 sowie die nicht weiter dargestellte Prüfleitung zur Temperaturmessung sind in jeweiligen speziell dafür angefertigten und hier nicht näher dargestellten Nuten entlang des Kontaktstifts 16 bis zu einem von den Kontaktsegmenten 18 abgewandten Längsende 48 verlegt. Dort können die Prüfleitungen 44, 46 sowie die nicht weiter dargestellte Prüfleitung zur Temperaturmessung an einem hier nicht gezeigten Anschluss angeschlossen werden, um die Widerstandsmessungen und Temperaturmessungen auswerten zu können. An diesem Anschluss kann eine nicht weiter dargestellte übergeordnete Steuereinheit angeschlossen werden. Die Sensormittel zur Widerstandsmessung sind dazu ausgebildet, die Widerstandsmessung repräsentierende Messdaten über die Prüfleitungen 44, 46 an die übergeordnete Steuereinheit zu übertragen. Ebenso ist das Sensormittel zur Temperaturmessung dazu ausgebildet, die Temperaturmessung repräsentierende Messdaten über die nicht weiter dargestellte Prüfleitung zur Temperaturmessung an die übergeordnete Steuereinheit zu übertragen.

Ein Gehäuseverschluss 50 dient dazu, die Führungshülse 20 in radialer Richtung im Gehäuseteil 24 zu fixieren. Eine Verschlussmutter 52 verbindet das Gehäuseteil 24 mit dem Kontaktstift 16 und verhindert so das Lösen des Kontaktstifts 16. Ein Gewinde 54 am Kontaktstift 16 nimmt dabei die Verschlussmutter 52 auf. Auf das Gewinde 54 ist zudem eine Kontermutter 56 aufgeschraubt. In axialer Richtung ist zwischen der Verschlussmutter 52 und der Kontermutter 56 genügend Platz, um beispielsweise einen Kabelschuh samt Leitung vorzusehen, um eine elektrische Versorgung des Hochstromkontakts 14 zu gewährleisten.

Der Kontaktstift 16 weist eine Kühlmittelbohrung 58 zum Zuführen eines gasförmigen Kühlmediums zu den Kontaktsegmenten 18 auf. Wie bereits erwähnt, können bei einem Prüfvorgang sehr hohe Ströme zwischen dem Hochstromkontakt 14 und der Hochstrombuchse 10 fließen. Infolgedessen können sich die Hochstrombuchse 10 und die Kontaktsegmente 18 stark erhitzen. An dem von den Kontaktsegmenten 18 abgewandten Längsende 48 ist ein Anschluss 60 zum Zuführen des gasförmigen Kühlmediums vorgesehen.

Mittels einer auf das Gewinde 54 geschraubten Überwurfmutter 62 kann beispielsweise ein Druckluftschlauch am Anschluss 60 fixiert werden. Der Anschluss 60 und die Kühlmittelbohrung 58 ermöglichen ein Kühlen des Hochstromkontakts 14, insbesondere der Kontaktsegmente 18, beispielsweise mittels Druckluft. Dies dient dazu, die Temperatur zu senken, welche bei hohen Strömen und besonders durch kurze Zykluszeiten hervorgerufen werden. Eine Testreihe hat gezeigt, dass sich bereits ab einem Druck von 1 Bar einer Druckluftversorgung die Temperatur eine Kontaktstelle, also an den Kontaktsegmenten 18 und der Innenkontaktfläche 12 der Hochstrombuchse 10 um die Hälfte reduziert.

Durch das Spannzangenprinzip der Kontaktsegmente 18 wird eine große Kontaktoberfläche erreicht, welche in Kombination mit der Kühlung eine sehr gute Wärmeabfuhr am Hochstromkontakt 14 und auch an der Hochstrombuchse 10 gewährleistet. Das erläuterte Prinzip des Hochstromkontakts 14 kann für verschiedenste Hochstrombuchsen 10 mit unterschiedlichsten Durchmessern verwendet werden.

### BEZUGSZEICHENLISTE

- 10: Hochstrombuchse
- 12: Innenkontaktfläche
- 14: Hochstromkontakt
- 16: Kontaktstift
- 18: Kontaktsegment
- 20: Führungshülse
- 22: Mutter
- 24: Gehäuseteil
- 26: stirnseitige Anlagefläche der Mutter
- 28: stirnseitige Anlagefläche der Hochstrombuchse
- 30: konischer Innenabschnitt der Führungshülse
- 32: konischer Außenabschnitt des Kontaktstifts
- 34: Rückstellfeder
- 36: Feder
- 38: Kragen des Kontaktstifts
- 40: Anlagefläche der Mutter
- 42: Bohrungen in den Kontaktsegmenten
- 44: Prüfleitung zur Widerstandsmessung
- 46: Prüfleitung zur Widerstandsmessung
- 48: von den Kontaktsegmenten abgewandtes Längsende des Kontaktstifts
- 50: Gehäuseverschluss
- 52: Verschlussmutter
- 54: Gewinde des Kontaktstifts
- 56: Kontermutter
- 58: Kühlmittelbohrung
- 60: Anschluss zum Zuführen des gasförmigen Kühlmediums
- 62: Überwurfmutter

## Patentansprüche

1. Hochstromkontakt (14) zum Kontaktieren einer Hochstrombuchse (10), umfassend
- einen Kontaktstift (16) zum Einführen in die Hochstrombuchse (10) mit mehreren in radialer Richtung geschlitzten Kontaktsegmenten (18) zum Kontaktieren einer Innenkontaktfläche (12) der Hochstrombuchse (10), **dadurch gekennzeichnet, dass**
- eine den Kontaktstift (16) umgebende Führungshülse (20), die durch zumindest mittelbares stirnseitiges Andrücken an die Hochstrombuchse (10) relativ zum Kontaktstift (16) in axialer Richtung von einer Ausgangsstellung, in der die Führungshülse (20) zur Vermeidung einer Berührung zwischen den axial aus der Führungshülse (20) herausragenden Kontaktsegmenten (18) und der Innenkontaktfläche (12) ein eigenständiges radiales Aufspreizen der Kontaktsegmente (18) sperrt, in eine gegenüber dem Kontaktstift (16) zurückversetzte Kontaktstellung bewegbar ist, in der die Führungshülse (20) ein eigenständiges radiales Aufspreizen der axial aus der Führungshülse (20) herausragenden Kontaktsegmente (18) zum Kontaktieren der Innenkontaktfläche (12) freigibt, wobei die Führungshülse (20) einen konischen Innenabschnitt (30) aufweist, der beim Bewegen der Führungshülse (20) von der Ausgangsstellung in die zurückversetzte Kontaktstellung mit einem konischen Außenabschnitt (32) des Kontaktstifts (16) zusammenwirkt und dadurch das eigenständige Aufspreizen der Kontaktsegmente (18) freigibt;
- wobei in zumindest einem Kontaktbereich der Kontaktsegmente (18) eine Prüfleitung (44, 46) zum Messen wenigstens einer physikalischen Eigenschaft mündet.

2. Hochstromkontakt (14) nach Anspruch 1,
**dadurch gekennzeichnet, dass**
die Führungshülse (20) unter Vermittlung einer Rückstellfeder (34) axial beweglich in einem Gehäuseteil (24) gelagert ist, welche auf die Führungshülse (20) eine Rückstellkraft in Richtung der Ausgangsstellung ausübt.

3. Hochstromkontakt (14) nach einem der vorhergehenden Ansprüche,
**dadurch gekennzeichnet, dass**
der Kontaktstift (16) unter Vermittlung einer Feder (36) mit der Führungshülse (20) verbunden ist.

4. Hochstromkontakt (14) nach einem der vorhergehenden Ansprüche,
**dadurch gekennzeichnet, dass**
der Kontaktstift (16) einen sich radial nach außen erstreckenden Kragen (38) aufweist, welcher eine Bewegung der Führungshülse (20) von der zurückversetzten Kontaktstellung über die Ausgangsstellung hinaus verhindert.

5. Hochstromkontakt (14) nach einem der vorhergehenden Ansprüche,
**dadurch gekennzeichnet, dass**
auf die Führungshülse (20) eine Mutter (22) mit einer stirnseitigen Anlagefläche (26) für die Hochstrombuchse (10) geschraubt ist, wobei durch axiale Positionsveränderung der Mutter (22) die zurückversetzte Kontaktstellung der Führungshülse (20) und damit die mittels der Kontaktsegmente (18) auf die Innenkontaktfläche (12) der Hochstrombuchse (10) ausübbare Kontaktkraft veränderbar ist.

6. Hochstromkontakt (14) nach einem der vorhergehenden Ansprüche,
**dadurch gekennzeichnet, dass**
die physikalische Eigenschaft ein elektrischer Widerstand und/oder eine Temperatur ist.

7. Hochstromkontakt (14) nach einem der vorhergehenden Ansprüche,
**dadurch gekennzeichnet, dass**
im zumindest einen Kontaktbereich der Kontaktsegmente (18) ein Sensormittel zur Widerstandsmessung angeordnet und mit der Prüfleitung (44, 46) verbunden ist, wobei das Sensormittel ausgebildet ist, die Widerstandsmessung repräsentierende Messdaten über die Prüfleitung (44, 46) an eine übergeordnete Steuereinheit zu übertragen.
in zumindest einem Kontaktbereich der Kontaktsegmente (18) eine Prüfleitung (44, 46) zur Widerstandsmessung mündet.

8. Hochstromkontakt (14) nach einem der vorhergehenden Ansprüche,
**dadurch gekennzeichnet, dass**
im zumindest einen Kontaktbereich der Kontaktsegmente (18) ein Sensormittel zur Temperaturmessung angeordnet und mit der Prüfleitung (44, 46) verbunden ist, wobei das Sensormittel ausgebildet ist, die Temperaturmessung repräsentierende Messdaten über die Prüfleitung (44, 46) an die übergeordnete Steuereinheit oder eine weitere Steuereinheit zu übertragen.

9. Hochstromkontakt (14) nach einem der vorhergehenden Ansprüche,
**dadurch gekennzeichnet, dass**
der Kontaktstift (16) eine Kühlmittelbohrung (58) zum Zuführen eines gasförmigen Kühlmediums zu den Kontaktsegmenten (18) aufweist.

10. Hochstromkontakt (14) nach Anspruch 9,
**dadurch gekennzeichnet, dass**
der Kontaktstift (16) auf seinem von den Kontaktsegmenten (18) abgewandten Längsende (48) einen Anschluss (60) zum Zuführen des gasförmigen Kühlmediums aufweist.

11. Hochstromkontakt (14) nach einem der vorhergehenden Ansprüche,
**dadurch gekennzeichnet, dass**
der Hochstromkontakt (14) eine Nickel-Silber-Beschichtung aufweist.

## Claims

1. High-current contact (14) for contacting a high-current socket (10), comprising
- a contact pin (16) for insertion into the high-current socket (10) having a plurality of contact segments (18), slotted in the radial direction, for contacting an inner contact surface (12) of the high-current socket (10), **characterized in that**
- a guide sleeve (20) which surrounds the contact pin (16) which, by at least indirectly pressing against the end side of the high-current socket (10) in the axial direction relative to the contact pin (16), can be moved from a starting position, in which the guide sleeve (20) blocks independent radial spreading of the contact segments (18) in order to avoid contact between the contact segments (18) protruding axially from the guide sleeve (20) and the inner contact surface (12), into a contact position, which is set back with respect to the contact pin (16) and in which the guide sleeve (20) allows independent radial spreading of the contact segments (18) protruding axially from the guide sleeve (20) for contacting the inner contact surface (12), wherein the guide sleeve (20) has a conical inner section (30) which, when the guide sleeve (20) moves from the starting position into the set-back contact position, interacts with a conical outer section (32) of the contact pin (16) and in this way allows independent spreading of the contact segments (18);
- wherein a test line (44, 46) for measuring at least one physical property leads into at least one contact region of the contact segments (18).

2. High-current contact (14) according to Claim 1, **characterized in that** the guide sleeve (20) is mounted in an axially movable manner in a housing part (24) with the interposition of a return spring (34) which exerts a return force on the guide sleeve (20) in the direction of the starting position.

3. High-current contact (14) according to either of the preceding claims, **characterized in that** the contact pin (16) is connected to the guide sleeve (20) with the interposition of a spring (36).

4. High-current contact (14) according to one of the preceding claims, **characterized in that** the contact pin (16) has a collar (38) which extends radially outwards and prevents movement of the guide sleeve (20) from the set-back contact position beyond the starting position.

5. High-current contact (14) according to one of the preceding claims, **characterized in that** a nut (22) with an end-side contact face (26) for the high-current socket (10) is screwed onto the guide sleeve (20), wherein the set-back contact position of the guide sleeve (20) and therefore the contact force which can be exerted onto the inner contact surface (12) of the high-current socket (10) by means of the contact segments (18) can be changed by changing the axial position of the nut (22).

6. High-current contact (14) according to one of the preceding claims, **characterized in that** the physical property is an electrical resistance and/or a temperature.

7. High-current contact (14) according to one of the preceding claims, **characterized in that** a sensor means for resistance measurement is arranged in at least one contact region of the contact segments (18) and connected to the test line (44, 46), wherein the sensor means is designed to transmit measurement data representing the resistance measurement to a superordinate control unit via the test line (44, 46), and a test line (44, 46) for resistance measurement leads into at least one contact region of the contact segments (18).

8. High-current contact (14) according to one of the preceding claims, **characterized in that** a sensor means for temperature measurement is arranged in at least one contact region of the contact segments (18) and connected to the test line (44, 46), wherein the sensor means is designed to transmit measurement data representing the temperature measurement to the superordinate control unit or a further control unit via the test line (44, 46).

9. High-current contact (14) according to one of the preceding claims, **characterized in that** the contact pin (16) has a coolant bore (58) for supplying a gaseous cooling medium to the contact segments (18).

10. High-current contact (14) according to Claim 9, **characterized in that** the contact pin (16), on its longitudinal end (48) which is averted from the contact segments (18), has a connection (60) for supplying the gaseous cooling medium.

11. High-current contact (14) according to one of the preceding claims, **characterized in that** the high-current contact (14) has a nickel-silver coating.

## Revendications

1. Contact pour courant fort (14) destiné à entrer en contact avec une douille pour courant fort (10), comprenant
- une broche de contact (16) destinée à être introduite dans la douille pour courant fort (10), comprenant plusieurs segments de contact (18) fendus dans la direction radiale destinés à entrer en contact avec une surface de contact interne (12) de la douille pour courant fort (10),
**caractérisé en ce que**
- un manchon de guidage (20) entourant la broche de contact (16), lequel peut être déplacé par une pression côté frontal au moins indirecte au niveau de la douille pour courant fort (10) par rapport à la broche de contact (16) dans la direction axiale depuis une position initiale, dans laquelle le manchon de guidage (20) bloque un écartement radial indépendant des segments de contact (18) afin d'éviter un contact entre les segments de contact (18) faisant saillie axialement hors du manchon de guidage (20) et la surface de contact interne (12), vers une position de contact reculée par rapport à la broche de contact (16), dans laquelle le manchon de guidage (20) libère un écartement radial indépendant des segments de contact (18) faisant saillie axialement hors du manchon de guidage (20) en vue d'entrer en contact avec la surface de contact interne (12), le manchon de guidage (20) possédant une portion intérieure (30) conique qui, lors du déplacement du manchon de guidage (20) de la position initiale dans la position de contact reculée, coopère avec une portion extérieure (32) conique de la broche de contact (16) et libère ainsi un écartement radial indépendant des segments de contact (18) ;
- une ligne de contrôle (44, 46) destinée à mesurer au moins une propriété physique débouchant dans au moins une zone de contact des segments de contact (18).

2. Contact pour courant fort (14) selon la revendication 1, **caractérisé en ce que** le manchon de guidage (20) est monté avec mobilité axiale dans une partie de boîtier (24) par l'intermédiaire d'un ressort de rappel (34), lequel exerce sur le manchon de guidage (20) une force de rappel en direction de la position initiale.

3. Contact pour courant fort (14) selon l'une des revendications précédentes, **caractérisé en ce que** la broche de contact (16) est reliée au manchon de guidage (20) par l'intermédiaire d'un ressort (36).

4. Contact pour courant fort (14) selon l'une des revendications précédentes, **caractérisé en ce que** la broche de contact (16) possède un collet (38) qui s'étend radialement vers l'extérieur, lequel empêche un mouvement du manchon de guidage (20) depuis la position de contact reculée au-delà de la position initiale.

5. Contact pour courant fort (14) selon l'une des revendications précédentes, **caractérisé en ce qu'**un écrou (22) pourvu d'une surface d'appui (26) côté frontal pour la douille pour courant fort (10) est vissé sur le manchon de guidage (20), la position de contact reculée du manchon de guidage (20), et ainsi la force de contact pouvant être exercée au moyen des segments de contact (18) sur la surface de contact interne (12) de la douille pour courant fort (10), pouvant être modifiées par un changement de position axiale de l'écrou (22).

6. Contact pour courant fort (14) selon l'une des revendications précédentes, **caractérisé en ce que** la propriété physique est une résistance électrique et/ou une température.

7. Contact pour courant fort (14) selon l'une des revendications précédentes, **caractérisé en ce qu'**un moyen capteur destiné à la mesure de résistance est disposé dans au moins une zone de contact des segments de contact (18) et relié à la ligne de contrôle (44, 46), le moyen capteur étant configuré pour transmettre à une unité de commande de niveau supérieur, par le biais de la ligne de contrôle (44, 46), des données de mesure représentant la mesure de résistance, une ligne de contrôle (44, 46) destinée à la mesure de résistance débouchant dans au moins une zone de contact des segments de contact (18).

8. Contact pour courant fort (14) selon l'une des revendications précédentes, **caractérisé en ce qu'**un moyen capteur destiné à la mesure de température est disposé dans au moins une zone de contact des segments de contact (18) et relié à la ligne de contrôle (44, 46), le moyen capteur étant configuré pour transmettre à l'unité de commande de niveau supérieur ou à une unité de commande supplémentaire, par le biais de la ligne de contrôle (44, 46), des données de mesure représentant la mesure de température.

9. Contact pour courant fort (14) selon l'une des revendications précédentes, **caractérisé en ce que** la broche de contact (16) possède un alésage à fluide de refroidissement (58) servant à l'acheminement d'un fluide de refroidissement gazeux vers les segments de contact (18) .

10. Contact pour courant fort (14) selon la revendication 9, **caractérisé en ce que** la broche de contact (16) possède, sur son extrémité longitudinale (48) à l'opposé des segments de contact (18), un raccord (60) servant à l'amenée du fluide de refroidissement gazeux.

11. Contact pour courant fort (14) selon l'une des revendications précédentes, **caractérisé en ce que** le contact pour courant fort (14) possède un revêtement nickel-argent.
